# EUROPEAN PATENT SPECIFICATION

(11) **EP 0 480 424 B1**
(45) Date of publication and mention of the grant of the patent: **08.09.1999**
(21) Application number: 91117296.3
(22) Date of filing: 10.10.1991
(51) Int. Cl.: H01J 37/28, H01J 37/30, G01B 15/00, G01B 15/04

(54) **Scanning electron microscope**
Rasterelektronenmikroskop
Microscope électronique à balayage

(30) Priority: 12.10.1990 JP 27225890
(43) Date of publication of application: 15.04.1992
(60) Divisional application: 99103918.1
(73) Proprietor: Hitachi, Ltd., Chiyoda-ku, Tokyo 101 (JP)
(72) Inventor: Todokoro, Hideo, Nishitama-gun, Tokyo (JP); Takamoto, Kenji, Ome-shi (JP); Otaka, Tadashi, Katsuta-shi (JP)
(74) Representative: Beetz & Partner Patentanwälte

(56) References cited:
- GB-A- 2 050 698
- US-A- 4 426 577
- PATENT ABSTRACTS OF JAPAN vol. 13, no. 248 (E-770)9 June 1989 & JP-A-1 048 470 ( HITACHI ) 22 February 1989
- PATENT ABSTRACTS OF JAPAN vol. 11, no. 304 (E-545)(2751) 3 October 1987 & JP-A-62 097 246 ( MITSUBISHI ELECTRIC )

## Description

The present invention relates to a scanning electron microscope according to the preamble of claim 1. Such a microscope is known from JP-A-1048470. The described apparatus is useful for observing surface configurations by using an electron beam and especially for observation of either configurations of the bottom of a deep hole or residues therein. It is used frequently in semiconductor manufacturing processes.

The scanning electron microscope, in which an electron beam is scanned on a specimen and secondary electrons generated from the specimen are detected, has been utilized widely in the field of biology and engineering. Especially, in the semiconductor industry, high-integration formation has been advanced and as a result, inspection based on optical microscopes has become impossible and the utilization of the scanning electron microscope has been promoted. In a scanning electron microscope used for semiconductors, it is general to use an electron beam of low energy of 1 kev or less in order to avoid charging on insulators.

In the semiconductor industry, the scanning electron microscope is utilized for not only inspection of appearance of completed semiconductors but also inspection in mid course of process. For example, it is used for inspection of appearance, inspection of dimension and inspection of through holes in mid course of process.

As a result of the advancement of high-integration formation of semiconductor devices, it has become impossible for the method using the conventional scanning electron microscope to inspect openings of through holes.

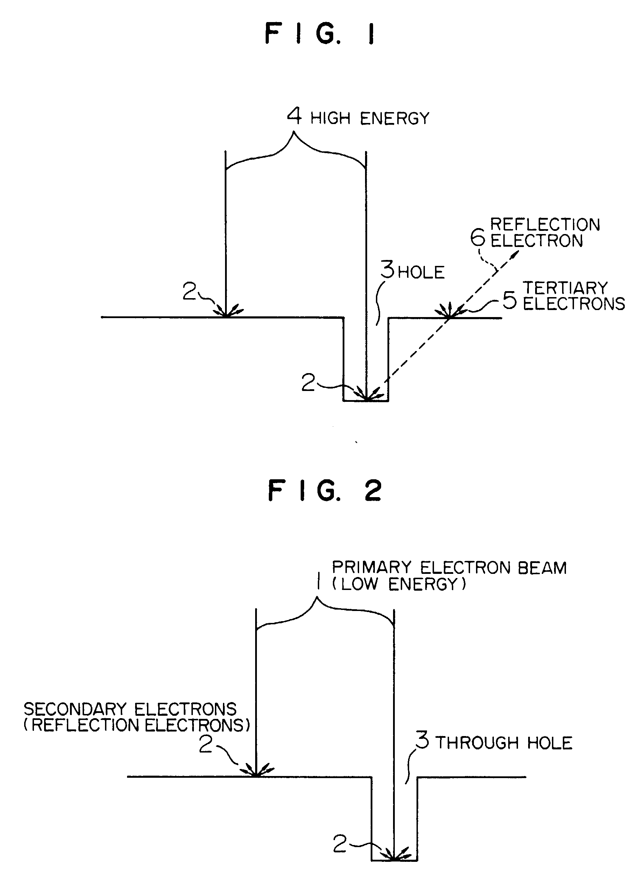

Referring to Fig. 2, problems encountered in observing a deep hole with the conventional scanning electron microscope will be described. Fig. 2 shows a case where a primary electron beam 1 of low energy irradiates a flat portion and a hole 3 of a specimen. Thanks to the absence of any obstacles, almost all of the number of secondary electrons 2 generated at the flat portion can be detected. Similarly, reflection electrons concurrently discharged can also be detected. In the case of irradiation on the hole 3, however, generated secondary electrons 2 impinge on the side wall of the hole 3 and consequently cannot escape from the hole 3 to the outside. Energy of reflection electrons is higher than that of secondary electrons but is not so high that the reflection electrons can penetrate through the side wall, and the reflection electrons are also blocked by the side wall.

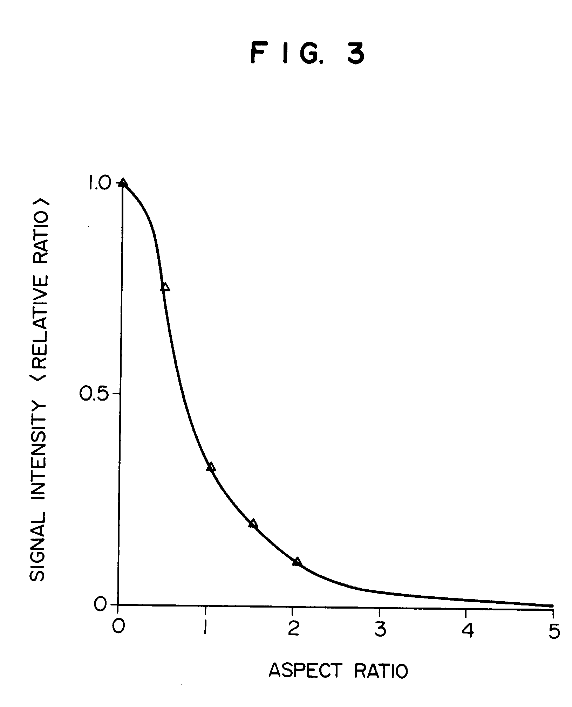

Fig. 3 shows results of calculation of the relation between the aspect ratio (depth/opening diameter) of a hole and the ratio of signals escaping from the hole. A signal at the surface (aspect ratio = 0) corresponds to 1. This calculation demonstrates that observation of holes of an aspect ratio exceeding 2 is impossible with the conventional scanning electron microscope.

JP-A-1048470 discloses an inspection apparatus.

This apparatus detects the absorption current caused by secondary and reflected electrons absorbed within a sample to be inspected.

It is the object of the invention to provide a scanning electron microscope allowing an improved inspection of holes with high aspect ratio within a sample. This object is solved in accordance with the features of claim 1. Dependent claims are directed on preferred embodiment of the invention.

Referring to Fig. 1, the principle of observation of deep holes by using a primary electron beam of high energy will be described.

A primary electron beam is used which has such high energy that allows reflection electrons generated at the bottom of a hole to have energy by which the reflection electrons can penetrate through the side wall of the hole.

A case where a primary electron beam 4 of high energy irradiates a surface portion resembles a case where the surface portion is irradiated with low energy. However, in the case of irradiation on the interior of a hole, the circumstances differ greatly. Secondary electrons 2 are absorbed by the side wall but reflection electrons 6 penetrate through the side wall to run out of the surface. When the reflection electrons 6 pass through the surface, they again generate secondary electrons. Here, these secondary electrons are called tertiary electrons 5. Since the tertiary electrons 5 or reflection electrons 6 have information about the bottom of the hole 3, an image of the interior of the hole can be obtained by detecting these electrons.

Namely, one of the aspects of the present invention resides in that the primary electron beam has high energy to allow reflection electrons to have energy sufficient for the reflection electrons to penetrate through the side wall, thereby permitting observation of the bottom of high-aspect-ratio holes which has hitherto been impossible. The primary electron beam penetrates a insulating layer (≤ 2 µm thickness) of a semiconductor device when it has energy sufficient for the reflection electrons to penetrate through the side wall. It results in allowing electrons in the insulating layer to move, i.e. the layer turns to have conductivity so that the layer is not subjected to charging on. Namely, when the primary electron beam has an energy level as defined by the present invention, the beam does not cause the insulating layer of the semiconductor device to charge on, either.

Fig. 1 is a diagram for explaining the principle of observation according to the invention;

Fig. 2 is a diagram for explaining a conventional observation method;

Fig. 3 is a diagram showing the relation between signal intensity from a hole and aspect ratio obtained in accordance with the conventional method;

Fig. 4 shows results of actual measurement of increased signals from the bottom of a hole which are obtained by increasing accelerating voltage (energy);

Fig. 5 is a diagram showing the relation between signal intensity and aspect ratio obtained when the invention is used;

Fig. 6 is a diagram for explaining a method of detecting tertiary electrons generated by reflection electrons from the bottom of a hole;

Fig. 7 is a diagram for explaining a method of observing reflection electrons from the bottom of a hole;

Fig. 8 is a diagram for explaining a method of observing both of reflection electrons and tertiary electrons simultaneously;

Fig. 9 is a diagram illustrative of detection of electrons transmitting through a specimen;

Fig. 10 is a diagram for explaining an embodiment of the invention which can permit observation of an object in wafer condition in accordance with the principle of observation and detection method according to the invention;

Fig. 11 is a diagram showing a flow for determining etching conditions by using the scanning electron microscope; and

Fig. 12 is a conceptual diagram of an arrangement in which a specimen chamber is provided in common for microwave etching and scanning electron microscope to facilitate determination of etching conditions.

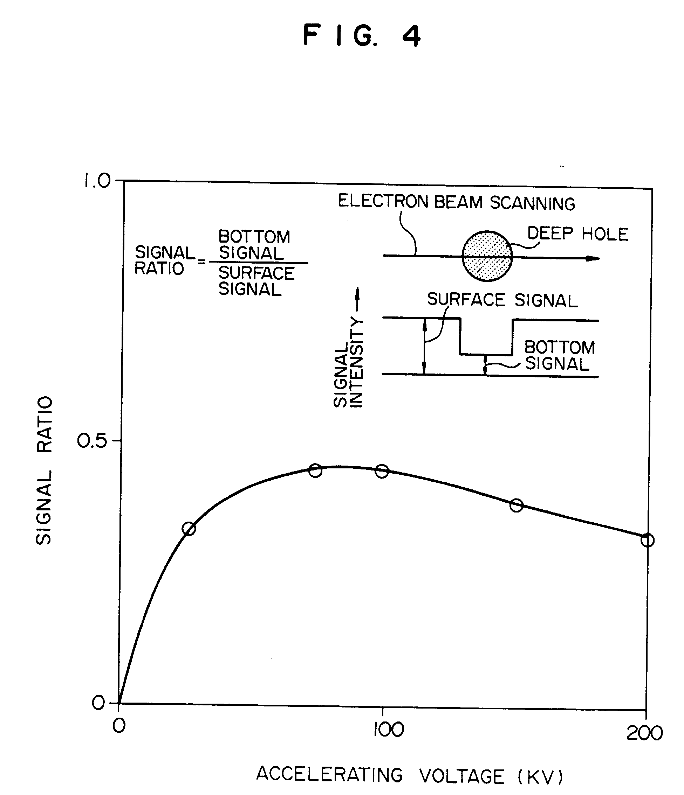

When a hole in SiO₂ having an aspect ratio of about 3 and a depth of 1.5 µm was observed, the ratio between signals from the bottom and the surface was measured by changing energy of a primary electron beam to obtain results as shown in Fig. 4. Namely, the ratio between tertiary electrons and secondary electrons was measured. It will be appreciated that the ratio is maximized around 100 kV of electron beam energy. When the primary electron beam has low energy, reflection electrons are absorbed by the side wall and therefore no tertiary electrons are generated. As energy of the primary electron beam increases, the number of reflection electrons penetrating through the side wall increases and hence the number of tertiary electrons is increased gradually. However, as the energy is further increased, the primary electron beam intrude into a specimen more deeply and the number of reflection electrons decreases, leading to a decrease in the number of tertiary electrons. This is the reason for existence of the maximum value. Electron beam energy corresponding to the maximum value is related to the depth and material of the hole. The deeper the hole and the denser the density of material, the higher the necessary energy becomes.

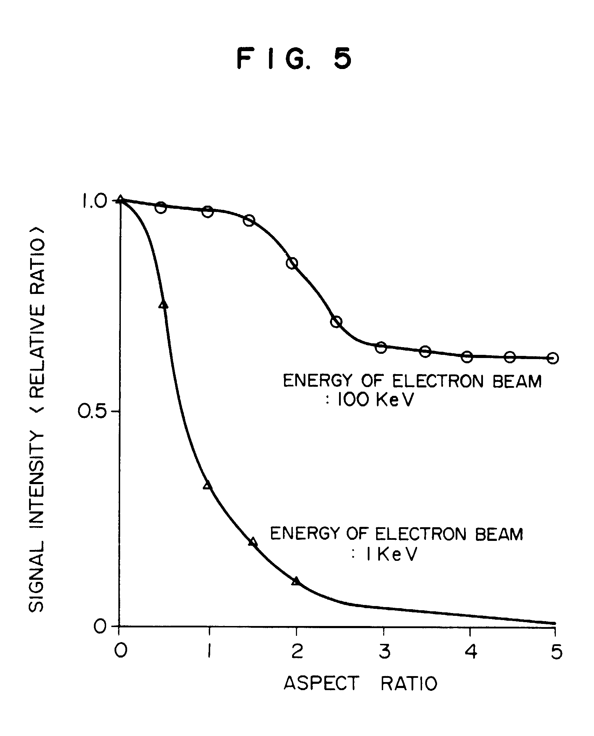

Fig. 5 shows the relation between the aspect ratio and the signal ratio obtained when a deep hole was observed by using 100 keV energy. The relation obtained with 1 keV is indicated for reference and it will be appreciated that with 100 keV, even when the aspect ratio exceeds 3, the signal ratio does not decrease and holes of higher aspect ratios can be observed.

In the conventional scanning electron microscope, the energy is less than 50 keV and high energy exceeding 50 keV is not used. This is because there was no concept of observation grounded on the principle described herein. Effectiveness of the high-energy primary electron beam permitting observation of deep holes is disclosed herein for the first time.

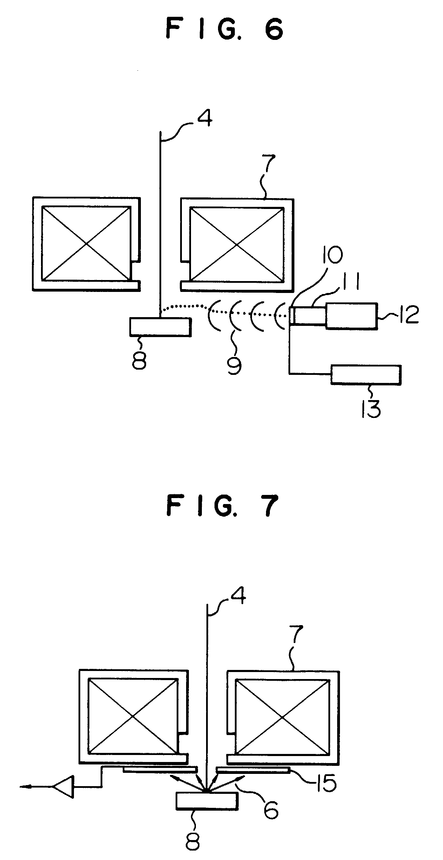

Fig. 6 shows a method of detecting tertiary electrons generated by reflection electrons of high energy. This method uses a scintillator 10 and a secondary-electron multiplier 12. Supplied to the scintillator 10 is a high voltage of 10 kV from a high voltage power supply 13. By using an attraction electric field 9 formed by the high voltage, tertiary electrons generated in the surface of a specimen 8 are detected. A primary electron beam 4 having energy sufficient to generate the tertiary electrons is focused and irradiated on the specimen 8 by means of an objective lens 7. In the Figure, circuits for scanning the primary electron beam and for displaying scanning images are omitted.

Fig. 7 shows an example of detecting not tertiary electrons but reflection electrons transmitting through the side wall. A reflection electron detector 15 having a large view angle relative to a specimen 8 is interposed between an objective lens 7 and the specimen 8. The reflection electron detector 15 may be a semiconductor detector having a PN-junction or a Schottky junction or may be based on a method of causing phosphors to luminescence and detecting luminescence (an example using a semiconductor is shown in the embodiment). Since energy of reflection electrons is high, the surface layer of the semiconductor detector is made to be thick (1 to 10 µm), thus preventing degradation of detection efficiency. In the case of phosphors, similar thickening is also employed. The thickness of the phosphor layer measures 10 to 100 µm, though depending on energy.

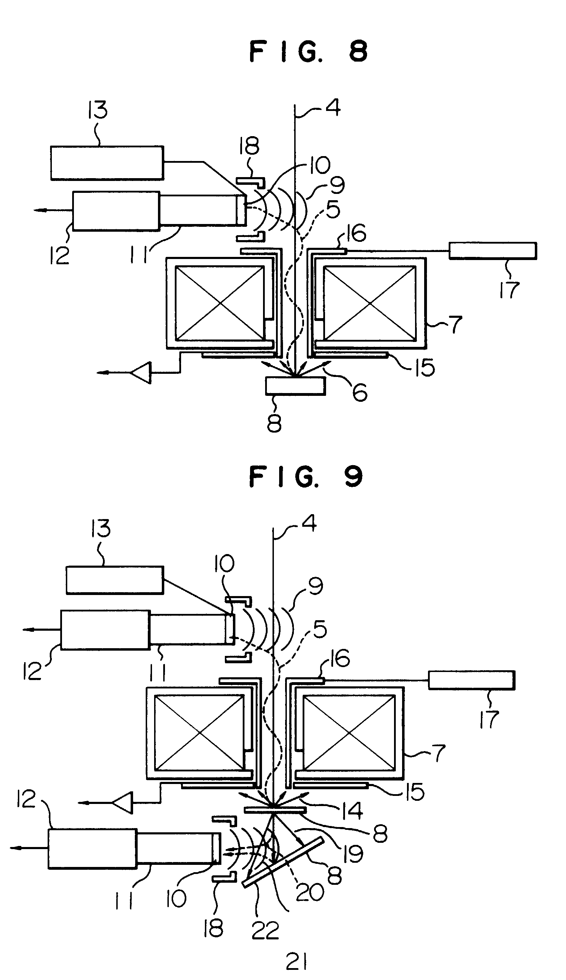

Fig. 8 shows an example where reflection electrons and tertiary electrons are both detected. An attraction electrode 16 is provided which passes through the center of an objective lens 7. Tertiary electrons 5 generated from a specimen 8 are drawn into a magnetic field of the objective lens 7 and pulled upwards by means of the attraction electrode 16. The tertiary electrons 5 thus pulled upwards are accelerated by an attraction electric field 9 formed by a scintillator 10 so as to impinge on the scintillator 10 and cause it to luminesce. Luminescent light is guided to a light guide 11 and amplified and converted into an electrical signal by means of a secondary-electron multiplier 12. Reflection electrons generated from the specimen 8 have high energy and therefore they are hardly deflected by an electric field formed by the attraction electrode 16, keeping substantially straight on and impinging upon a reflection electron detector 15. Through this process, the reflection electrons themselves and the tertiary electrons can be detected distinctively. Since scanning images formed by the two types of electrons are delicately different from each other, it is possible to take such a process as selecting one of the images which has better contrast or performing addition/subtraction to improve contrast.

In the foregoing embodiments, tertiary electrons and reflection electrons generated on the side upon which the primary electron beam is incident but when the specimen is thin, either tertiary electrons generated by transmitted electrons or the transmitted electrons may be detected.

Fig. 9 shows an embodiment in which tertiary electrons generated on the side opposite the primary electron beam and transmitted electrons are detected. The manner of detection on the primary electron beam side is the same as that in the previously-described embodiment. Tertiary electrons 20 generated from the under surface of a specimen 8 by electrons transmitting through the specimen and tertiary electrons 21 generated by impingement of transmitted electrons 19 upon a reflection plate 22 are detected by using a scintillator 10, a light guide 11 and a secondary-electron multiplier 12. Electrons of a primary electron beam of 200 keV energy have a range of 200 µm and can transmit through even a Si wafer used in the semiconductor industry. Namely, by detecting transmitted electrons and tertiary electrons generated from the under surface of the specimen, a hole formed in the surface of the specimen 8 can be observed.

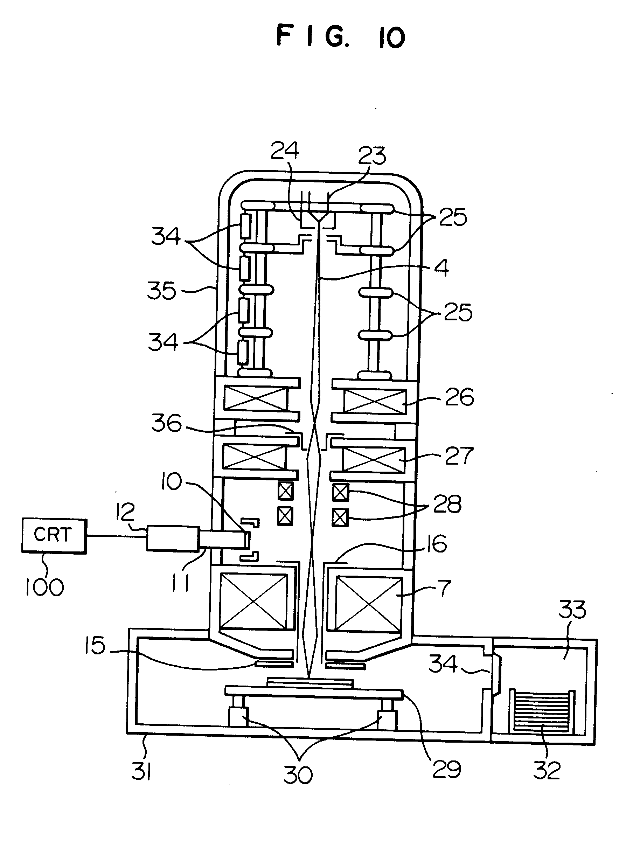

Fig. 10 shows a scanning electron microscope using the principle of observation and the detection method described previously. A source of electrons is a single crystal of LaB₆ and the single crystal is heated to emit electrons to be used. Emitted electrons are controlled by means of a Whenelt 24. The emitted electrons are accelerated by accelerating electrodes 25. Accelerating voltage (energy) in the present embodiment has a maximum value of 200 keV. An accelerating electrode 25 of the uppermost stage is applied with the accelerating voltage and divisional voltages due to dividing resistors 34 are applied to individual accelerating electrodes 25. Here, cable and power supply for application of the accelerating voltage are omitted. An accelerating unit including the accelerating electrodes 25 is shielded with a high voltage shield 35. An accelerated primary electron beam 4 is reduced in size by means of a first condenser lens 26, a second condenser lens 27 and an objective lens 7. When an objective lens having a focal distance of 30 mm is used, a resolution value of 3 nm can be obtained at 200 keV. The aperture of electron beam is determined by an aperture 36 placed on the second condenser lens 27. Scanning of the electron beam is carried out by a scanning coil 28. The scanning coil is constructed of two stages of coils so that the electron beam subject to scanning may pass through the center of the objective lens 7. Reflection electrons reflected at a specimen is detected by a reflection electron detector 15 and tertiary electrons are led upwardly of the objective lens 7 and detected by a detector comprised of a scintillator 10, a light guide 11 and a secondary-electron multiplier 12.

The specimen is a wafer of 4 inches or more and carried on an XY fine movement stage 29. The specimen can be inclined by ±15 degrees in desired directions by means of a specimen inclination fine movement section 30. The specimen inclination fine movement section 30 has three posts and the length of each post can be controlled by a computer. A wafer to be observed is contained in a dedicated cassette 32 and the cassetted is stored in a preparatory chamber 33. When conducting observation, a valve 34 is opened and the specimen is brought onto the XY fine movement stage 29 by using an exchange mechanism (not shown). When the same portion of the specimen is observed by changing the inclination angle, the height can be measured (stereo-measurement).

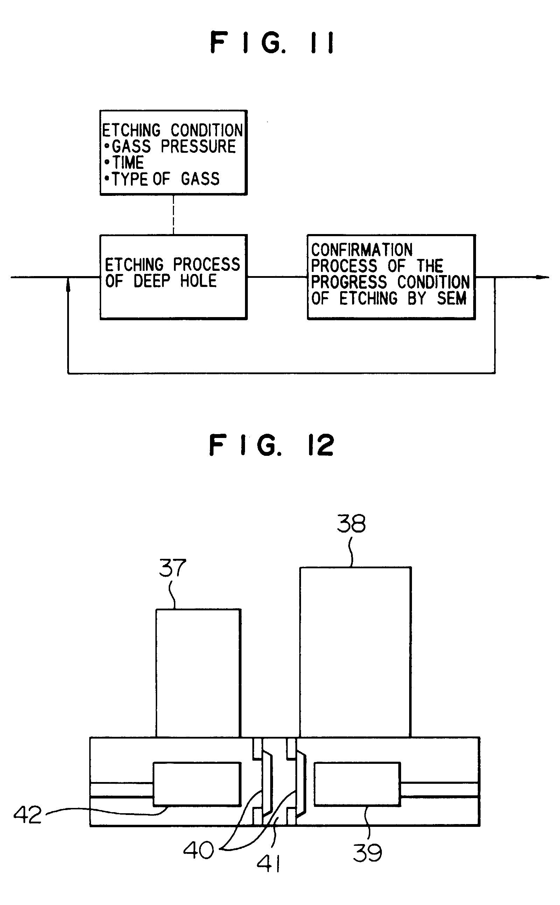

In highly integrated semiconductor devices, the etching process for working a deep hole of high aspect ratio is important as has already been described. Etching for working a deep hole of high aspect ratio is very difficult and for determination of etching conditions, observation of the bottom of the deep hole and confirmation of the progress condition of etching are needed. Fig. 11 shows a flow of the confirmation wherein in accordance with the results of confirmation, feedback for urging, for example, re-etching is undertaken to ensure integrity of process. The thus determined etching conditions are relayed to the succeeding process. By repeating the confirmation at a fixed period, the process can be made to be stabler. The scanning electron microscope is very effective for the confirmation of etching and can contribute to improvement in yield of production of highly-integrated devices. Especially, the high-energy scanning electron microscope utilizing tertiary electrons described so far is effective.

Fig. 12 shows an arrangement contrived to simplify the aforementioned confirmation process and in which a specimen chamber is provided in common for a microwave etching apparatus 38 and a high-energy scanning electron microscope 37, and etching and inspection can be carried out alternately by merely moving a specimen from an etching apparatus specimen stage 39 to a scanning electron microscope XY fine movement stage 42. The degree of vacuum in the microwave etching apparatus is 10⁻⁴ Torr which is comparable to that in the scanning electron microscope but because of the use of inert gas, an intermediate chamber 41 is provided in the present embodiment in order that the inert gas can be prevented from flowing into the scanning electron microscope by switching valves 40 for intermediate chamber alternately. In the Figure, the evacuation system is omitted.

As described above, in accordance with the principle of observation according to the invention, deep holes of which observation was impossible in the past can be observed. This implies that inspection can be carried out in line in the process of semiconductor device production, resulting in very beneficial effects.

## Claims

1. A scanning electron microscope for the observation of surface configurations of semiconductor devices having grooves or deep holes or residues therein or the like, comprising
means for irradiating said semiconductor device (8) with a primary electron beam (4) and means (10, 11, 12, 15) for detecting the reflected electrons (6) and/or other electrons from the surface of the semiconductor device (8),
**characterized** in that the scanning electron microscope further comprises means for setting
the energy of the primary electron beam (4) sufficiently high to lead to a penetration through the body of the semiconductor device (8) of electrons reflected from side walls or the bottom of said grooves or holes in the semiconductor device so as to radiate from the surface of the semiconductor device (8) and/or to produce tertiary electrons in the surface of the semiconductor device.

2. A microscope according to claim 1,
characterized in that
the irradiation means for the primary electron beam (4) includes a final lens (7) for focussing the beam (4), and further comprises an electron-ray detector (10, 11, 12, 15, 16, 17, 18) above the final lens, and
the tertiary electrons (5) caused to pass through the lens (7) are detected.

3. A microscope according to claim 1,
characterized in further comprising
means (100) for imaging of the surface of the object (8) to be inspected according to detection signals generated by the detecting means (10, 11, 12, 15), wherein the detection signals result from arithmetic operation of the reflection electrons (6) and the tertiary electrons (5).

4. A microscope according to claim 1,
characterized in that
the energy of the primary electron beam (4) exceeds 50 keV.

5. A microscope according to claim 1,
characterized in that
a stage (29) is provided into which the object (8) having a diameter in excess of 101.6 mm (4 inches) can be inserted and which is adjustable in inclination angle.

## Patentansprüche

1. Rasterelektronenmikroskop zum Beobachten von oberflächenkonfigurationen von Halbleitervorrichtungen mit Gräben oder tiefen Löchern oder Rückständen darauf oder ähnlichem, mit
einer Einrichtung zum Bestrahlen der Halbleitervorrichtung (8) mit einem Primärelektronenstrahl (4), und
einer Einrichtung (10, 11, 12, 15) zum Erfassen der reflektierten Elektronen (6) und/oder anderer Elektronen von der Oberfläche der Halbleitervorrichtung (8),
dadurch gekennzeichnet, daß
das Rasterelektronenmikroskop außerdem eine Einrichtung aufweist zum Einstellen der Energie des Primärelektronenstrahls (4) so, daß sie ausreichend hoch ist, daß sie zu einem Durchdringen der Elektronen, die von den Seitenwänden oder dem Boden der Gräben oder der Löcher in der Halbleitervorrichtung reflektiert werden, durch den Körper der Halbleitervorrichtung (8) führt, so daß sie von der Oberfläche der Halbleitervorrichtung (8) abstrahlen und/oder an der Oberfläche der Halbleitervorrichtung Tertiärelektronen erzeugen.

2. Mikroskop nach Anspruch 1, dadurch gekennzeichnet, daß die Erfassungseinrichtung (10, 11, 12) die an der Oberfläche des Objekts (8) erzeugten Tertiärelektronen (5) anhand von Reflexionselektronen (6) erfaßt, die an der Seitenwand oder am Boden des Grabens oder des Lochs erzeugt werden und die durch das Objekt (8) dringen.

3. Mikroskop nach Anspruch 1, dadurch gekennzeichnet, daß die Erfassungseinrichtung (15) die an der Seitenwand oder dem Boden des Grabens oder des Lochs erzeugten Reflexionselektronen (6) erfaßt, die das Objekt (8) durchdringen.

4. Mikroskop nach Anspruch 1, dadurch gekennzeichnet, daß die Bestrahlungseinrichtung für den Primärelektronenstrahl (4) eine Endlinse (7) zum Fokussieren des Strahls (4) sowie einen Elektronenstrahldetektor (10, 11, 12, 15, 16, 17, 18) oberhalb der Endlinse aufweist, wobei die durch die Linse (7) geleiteten Tertiärelektronen (5) erfaßt werden.

5. Mikroskop nach Anspruch 1, weiter gekennzeichnet durch eine Einrichtung (100) zum Abbilden der Oberfläche des zu untersuchenden Objekts (8) entsprechend dem von der Erfassungseinrichtung (10, 11, 12, 15) erzeugten Erfassungssignalen, wobei die Erfassungssignale aus arithmetischen Operationen hervorgehen, die auf die Reflexionselektronen (6) und die Tertiärelektronen (5) Bezug nehmen.

6. Mikroskop nach Anspruch 1, dadurch gekennzeichnet, daß die Energie des Primärelektronenstrahls (4) 50 keV übersteigt.

7. Mikroskop nach Anspruch 1, dadurch gekennzeichnet, daß eine Bühne (29) vorgesehen ist, in die das Objekt (8) mit einem Durchmesser größer als 101,6 mm (4 Inch) eingelegt werden kann und die hinsichtlich ihres Neigungswinkels einstellbar ist.

## Revendications

1. Un microscope électronique à balayage pour l'observation de configurations de surface de dispositifs semi-conducteurs comportant des rainures ou des trous profonds ou des résidus, ou autres, comprenant :
des moyens pour irradier ledit dispositif semi-conducteur (8) avec un premier faisceau électronique (4) et
des moyens (10, 11, 12, 15) pour détecter les électrons réfléchis (6) et/ou d'autres électrons provenant de la surface du dispositif semi-conducteur (8),
caractérisé en ce que le microscope électronique à balayage comprend en outre des moyens pour régler le faisceau d'électrons primaire (4) suffisamment fort pour provoquer une pénétration à travers le corps du dispositif semi-conducteur (8) d'électrons réfléchis à partir de parois latérales ou du fond desdites rainures ou desdits trous dans le dispositif semi-conducteur afin qu'ils rayonnent de la surface du dispositif semi-conducteur (8) et/ou qu'ils produisent des électrons tertiaires dans la surface du dispositif semi-conducteur.

2. Un microscope selon la revendication 1, caractérisé en ce que les moyens de détection (10, 11, 12) détectent les électrons tertiaires (5) générés dans la surface de l'objet (8) par les électrons de réflexion (6) qui sont générés à partir de la paroi latérale ou du fond de la rainure ou du trou, et qui pénètrent à travers l'objet (8).

3. Un microscope selon la revendication 1, caractérisé en ce que le moyen de détection (15) détecte les électrons de réflexion (6) générés à partir de la paroi latérale ou du fond de la rainure ou du trou et qui pénètrent à travers l'objet (8).

4. Un microscope selon la revendication 1, caractérisé en ce que les moyens d'irradiation pour le faisceau électronique primaire (4) comprennent une lentille terminale (7) pour focaliser le faisceau (4), et comprennent en outre un détecteur de syntonisation (10, 11, 12, 15, 16, 17, 18) au-dessus de la lentille terminale, les électrons tertiaires (5) qui sont amenés à passer dans la lentille (7) étant détectés.

5. Un microscope selon la revendication 1, caractérisé en ce qu'il comprend en outre des moyens (100) pour mettre en image la surface de l'objet (8) à inspecter en fonction de signaux de détection produits par les moyens de détection (10, 11, 12, 15, les signaux de détection résultant d'une opération arithmétique sur les électrons de réflexion (6) et des électrons tertiaires (5).

6. Un microscope selon la revendication 1, caractérisé en ce que la puissance du faisceau d'électrons primaires (4) dépasse 50 KeV.

7. Un microscope selon la revendication 1, caractérisé en ce qu'une platine (29) est prévue, dans laquelle l'objet (8) ayant un diamètre supérieur à 101,6 mm (4 pouces) peut être inséré, et qui est réglable en inclinaison.
